# EUROPEAN PATENT APPLICATION

(11) **EP 4 219 636 A1**
(43) Date of publication of application: **02.08.2023**
(21) Application number: 21872950.7
(22) Date of filing: 24.09.2021
(51) Int. Cl.: C09D 5/28, C09D 167/00, C09D 7/40, C08K 3/013, C08K 3/34, C08K 3/04, C08K 5/3492, C08K 5/42

(54) **COMPOSITE RESIN COMPOSITION HAVING EXCELLENT WEATHER RESISTANCE AND HEAT-RADIATION CHARACTERISTICS, COMPOSITE-RESIN-COATED STEEL SHEET AND METHOD FOR MANUFACTURING SAME**

(30) Priority: 28.09.2020 KR 20200125987
(71) Applicant: POSCO Co., Ltd, Pohang-si, Gyeongsangbuk-do 37859 (KR)
(72) Inventor: JO, Du-Hwan, Pohang-si, Gyeongsangbuk-do 37877 (KR); PARK, Young-Jun, Pohang-si, Gyeongsangbuk-do 37877 (KR); EUN, Hee-Jea, Pohang-si, Gyeongsangbuk-do 37877 (KR)
(74) Representative: Meissner Bolte Partnerschaft mbB
(86) International application number: PCT/KR2021/013054
(87) International publication number: WO 2022/065922

(57) **Abstract**

The present invention relates to, in the provision of a material that has excellent weather resistance and heat-radiation characteristics, and thus, is suitable for solar cells, a composite resin composition having excellent weather resistance and heat-radiation characteristics, a composite-resin-coated steel sheet obtained therefrom, and a method for manufacturing same.

## Description

### Technical Field

The present disclosure relates to a composite resin composition having excellent weather resistance and heat-radiation characteristics, a composite resin coated-steel sheet, and a method for manufacturing the same.

### Background Art

Recently, a solar cell using sunlight has been in the spotlight as eco-friendly energy (generation device) that can overcome environmental problems such as CO₂ generation and fine dust generation due to excessive use of fossil fuels. Such a solar cell is used in a technology converting light energy into electrical energy by a photoelectric effect.

The solar cell, most commonly used in a solar technology is a silicon-based solar cell, which has a crystalline type and amorphous type. Recently, CuInGaSe (CIGS) solar cell technology has been greatly developed according to the development of thin-film technology.

In particular, a technology for manufacturing an integrated solar module for application to a roof or wall of a building using CIGS thin-film solar cells has been greatly developed.

However, while the technology for manufacturing a solar module has a great advantage as an eco-friendly energy technology, it has two problems to be overcome.

First, there is a structural problem. A crystalline silicon module is comprised of upper tempered glass, an encapsulant, a solar cell, an encapsulant, and a lower backsheet in order, so that a weight of the solar module is heavy and safety of the environment is insufficient. Due thereto, since an additional robust structure may be installed in a building, and a module may be installed thereon, there may be a disadvantage in that installation costs increase.

Second, there is a heat problem, since the solar cell produces electricity using properties of a semiconductor, the solar cell is not only highly dependent on an amount of sunlight, but also has a problem in that power generation efficiency is greatly reduced when a temperature in summer becomes high. Roughly, when a surface temperature of the module is 45°C or higher, the power generation efficiency is rapidly reduced to -0.45%/°C, and when the surface temperature of the module of the solar module is maintained to have a high temperature of about 60 to 80°C during the summer when an air temperature is the highest, average solar power generation efficiency may drop from 20% to 12%.

In order to compensate for these problems, a method of attaching a thermal radiation sheet or thermal radiation fin or installing an additional cooling device such as a thermal radiation fan has been applied, but it is not preferable in terms of efficiency or cost.

In addition, since buildings such as roofs or walls to which solar modules are applied are exposed to outdoors and used, the weather resistance of the back sheet is required so that it can be stably used in an environment of 20 years or more.

(Patent Document 1) Korean Patent Registration No. 10-1487962

### Summary of Invention

### Technical Problem

An aspect of the present disclosure is to provide in providing, a material having excellent weather resistance and heat-radiation characteristics, and thus being suitable for solar cells, a composite resin composition having excellent weather resistance and heat-radiation characteristics and a composite-resin-coated steel sheet obtained therefrom, and a method for manufacturing the same.

The subject of the present invention is not limited to the above. The subject of the present invention will be understood from the overall content of the present specification, and those of ordinary skill in the art to which the present invention pertains will have no difficulty in understanding the additional subject of the present invention.

### Solution to Problem

According to an aspect of the present disclosure, a composite resin composition having excellent weather resistance and heat-radiation characteristics is provided, the composite resin composition including, with respect to a total of 100 parts by weight:

(a) 20 to 60 parts by weight of a main resin made of a modified polyester resin, (b) 3 to 20 parts by weight of a curing agent, (c) pigment: 1 to 20 parts by weight of an anti-corrosive pigment, 1 to 20 parts by weight of a thermally-conductive pigment, (d) catalyst: 0.05 to 3.0 parts by weight of an acid catalyst, 0.05 to 5.0 parts by weight of an amine-based catalyst, (e) 0.05 to 5.0 parts by weight of a wax, and (d) a remainder of solvent,

According to another aspect of the present disclosure, a composite-resin-coated steel sheet is provided, the composite-resin-coated steel sheet including: a plated steel sheet; a thermal radiation coating layer on a first surface of the plated steel sheet; and a weather resistance coating layer on a second surface of the plated steel sheet, wherein the thermal radiation coating layer is formed by the composition to form a wrinkle pattern or a concavo-convex structure on a surface thereof, and the weather resistance coating layer is formed by a composition excluding some catalysts and wax components from the above-described composition.

According to another aspect of the present disclosure, a method for manufacturing a composite-resin-coated steel sheet is provided, the method including operations of: a) preparing a plated steel sheet; b) applying a composition of claim 1 to a first surface of the plated steel sheet and applying a composition of claim 2 to a second surface thereof; and c) drying the composition applied to the first and second surfaces at 180 to 260°C based on a peak metal temperature (PMT), wherein the second surface is a surface contacted to a solar module.

### Advantageous Effects of Invention

As set forth above, according to the present disclosure, the composite-resin-coated steel sheet obtained by using the composite resin composition according to the present disclosure has excellent weather resistance and heat-radiation characteristics, and thus is suitable as a roofing material for solar cells, or the like, thereby improving the power generation efficiency of solar cells.

### Brief description of drawings

FIG. 1 is a side cross-sectional view of a composition-resin-coated steel sheet according to an embodiment of the present disclosure.
FIG. 2 illustrates results of observing a coating layer (a thermal radiation coating layer) of Inventive steel 10(a) and Comparative steel 1(b) with a microscope.
FIG. 3 illustrates results of measuring surface roughness of a coating layer of Inventive steel 10 and Comparative steel 1 according to an embodiment of the present disclosure.
FIG. 4 illustrates an apparatus for measuring a thermal radiation temperature according to an embodiment of the present disclosure.
FIG. 5 illustrates results of measuring thermal radiation characteristics of Inventive steel 10, Comparative steel 1, and Contrast steel material according to an embodiment of the present disclosure.

### Best Mode for Invention

The inventors of the present invention have studied in depth to solve a problem of technology for manufacturing of an existing integrated solar module. In particular, in developing a material suitable for buildings such as roofs or walls to which a solar module is applied, the present inventors have found that a plated steel sheet known to have excellent corrosion resistance, is utilized, but a composition having excellent weather resistance and heat-radiation characteristics is coated so that a coated steel sheet suitable for the material may be provided, thereby completing the present invention.

Hereinafter, the present disclosure will be described in detail.

First, a composite resin composition having excellent weather resistance and heat-radiation characteristics will be specifically described.

The composite resin composition according to the present disclosure may be comprised of a main resin, a curing agent, a pigment, a catalyst, and a remainder of solvent, and may be comprised of a composition further including a wax component and a composition excluding some catalysts and wax components. In the present specification, it should be noted that the composite resin composition further including the wax component may be referred to as Composition 1, and another composite resin composition may be referred to as Composition 2.

As will be described in detail later, in the Composition 1 and the Composition 2 of the present disclosure, respective coating layers may be formed on a surface of a substrate to which the composition may be applied, and the coating layers may have surface shapes that are distinguished from each other. In other words, the Composition 1 and Composition 2 may be applied to different surfaces of the substrate to form a coating film in a dried state. Although described in more detail later, in the present disclosure, the substrate may be a metal material, for example, a plated steel sheet.

First, the above-described compositions will be described in detail.

The Composition 1 may include: (a) a main resin made of a modified polyester resin; (b) a curing agent; (c) a pigment comprised of an anti-corrosive pigment, and a thermally-conductive pigment;(d) a catalyst comprised of an acid catalyst an amine-based catalyst; and (e) a wax. Composition 1 as described above may form a certain pattern such as a wrinkle pattern or a concavo-convex structure on a surface of the coating film in a dried state.

Hereinafter, a preferable content of each component is described in detail, and it should be noted that the content of each component is based on a total of 100 parts by weight.

20 to 60 parts by weight of the main resin (a) made of the modified polyester resin may be included based on a total of 100 parts by weight.

The polyester resin is a main component for forming a coating film (coating layer), and in the present disclosure, a modified polyester resin having an average molecular weight (Mw) of 5,000 to 50,000 may be used. If the molecular weight is less than 5,000, chemical resistance and processability of the coating film may be insufficient. On the other hand, if the molecular weight exceeds 50,000, there is a problem in that storage stability and workability of the solution are inferior. More advantageously, an average molecular weight may be 10,000 to 40,000.

The modified polyester resin may have a hydroxyl group (OH group, hydroxyl group). Preferably, the resin may have a hydroxyl number of 20 to 60, and more advantageously, a hydroxyl number of 30 to 50. If the hydroxyl number is less than 20, cross-linking properties of the coating film may decrease. On the other hand, if the hydroxyl number exceeds 60, chemical resistance of the coating film may deteriorate.

In addition, the modified polyester resin may have an acid value of 1 to 20 mgKOH/g, preferably 5 to 15 mgKOH/g. If the acid value exceeds 20 mgKOH/g, the chemical resistance of the coating film deteriorates. On the other hand, if the acid value is less than 1 mgKOH/g, the cross-linking properties of the coating film may deteriorate.

If a content of the above-described modified polyester resin in the composition provided in the present invention is less than 20 parts by weight or exceeds 60 parts by weight, there is a concern that drying properties, cross-linking properties, or chemical resistance may be reduced during curing of the coating film.

In the present disclosure, the modified polyester resin is a bind resin forming a fine pattern, for example, a wrinkle pattern or a concavo-convex structure on a surface of a coating film when cured, and has excellent processability and weather resistance.

The (b) curing agent may be included in 3 to 20 parts by weight based on the total of 100 parts by weight, and more advantageously may be included in 5 to 15 parts by weight.

The curing agent may be added to form a dense cured film in terms of physical properties of the coating film, and the curing agent is preferably an amine-based curing agent.

More preferably, the amine-based curing agent may be a melamine-based curing agent. Although not limited thereto, the melamine-based curing agent may be at least one of selected from hexa (N-butoxy) methylmelamine, hexa (Isobutoxy) methylmelamine, hexa (N-propyl) methylmelamine, hexa (Iso-propyl) methylmelamine, hexaethoxymethylmelamine, and hexamethoxymethylmelamine. That is, the melamine-based curing agent may be used as a compound alone or as a mixture of two or more.

In the composition provided by the present disclosure, if a content of the amine-based curing agent is less than 3 parts by weight or exceeds 20 parts by weight, it may be disadvantageous in forming a dense cured film.

In forming a coating film (coating layer) with the composition provided in the present disclosure, a pigment may be included in the composition to improve corrosion resistance of the coating film.

In the present disclosure, the pigment (c) may include a mixture of an anti-corrosive pigment and a thermally-conductive pigment, and may include 1 to 20 parts by weight of each of the pigments based on the total 100 parts by weight, more advantageously 5 to 15 parts by weight thereof.

The anit-corrosive pigment is preferably a silicate compound, and as one example, the anti-corrosive pigment may be at least one of lithium polysilicate, sodium polysilicate, potassium polysilicate, and colloidal silica. However, the present disclosure is not limited thereto.

The thermally-conductive pigment is preferably a component capable of realizing a black color when forming a coating film, and in the present disclosure, the thermally-conductive pigment is preferably an organic-inorganic thermally-conductive pigment. As an example, the organic-inorganic thermally-conductive pigment may be at least one of carbon black, carbon nanotubes, graphite, and graphene, but the present disclosure is not limited thereto.

If a content of the anti-corrosive pigment in the composition provided in the present disclosure is less than 1 part by weight, an effect of corrosion resistance is insufficient, and if the content thereof exceeds 20 parts by weight, the corrosion resistance is improved, but the coating film roughness is increased, resulting in poor processability. If a content of the thermally conductive pigment in the composition is less than 1 part by weight, a hiding rate and heat-radiation characteristics of a material due to the formation of a coating film may be lowered. On the other hand, if the content thereof exceeds 20 parts by weight, viscosity of a solution applied thereto increases, so that workability may deteriorate, and it may be difficult to obtain a desired surface appearance.

Meanwhile, when carbon black is used as the thermally-conductive pigment, an average particle diameter is preferably 10 to 100 nm, more advantageously 10 to 30 nm, in consideration of dispersibility.

When graphite is used as the thermally-conductive pigment, the average particle diameter thereof is preferably 3 to 30 um, more advantageously 5 to 20 um. The graphite may have various shapes such as granular, plate, bulk, and flake shapes, and there is no problem in applying any of these shapes thereamong. However, in order to impart excellent thermal conductivity to the produced coating film, the graphite is preferably a flake shape.

Meanwhile, when a certain pattern is formed on a surface of the coating film by the composition provided in the present disclosure, as pigment particles are continuously arranged inside the pattern, hardness of the coating film increases, and design having improved texture thereof may be imparted. To this end, it is preferable that the average particle diameter of the pigment particles satisfies a range of 2015 um based on a thickness of the coating film of the composition in a dried state.

In order to improve the hardness of the coating film by accelerating a curing reaction of the binder resin and the curing agent, which are the main components of the composition provided in the present disclosure, a catalyst may be included as a curing accelerator.

In the present disclosure, the (d) catalyst may include a mixture of an acid catalyst and an amine-based catalyst, and may include 0.05 to 3.0 parts by weight and 0.05 to 5.0 parts by weight, respectively, based on the total of 100 parts by weight.

The acid catalyst may be a material blocked with an organic chain that can be dissociated by heat, and sulfonic acid may be preferably used as the acid catalyst, but it should be noted that it is not limited thereto.

Examples of the sulfonic acid may include p-toluenesulfonic acid, dodecylbenzenedisulfonic acid, dinonyltoluenedisulfonic acid, dinonylnaphthalenesulfonic acid, or a mixture thereof, and in the case of the mixture, two or more compounds may be mixed. In addition, an epoxy resin-based or amine-based compound may be used as a material for the blocking. As one example, dinonylsulfonic acid (a material having a dissociation temperature of 160°C or higher and a degree of activity of 30%, manufactured by King, USA), shielded with an epoxy resin may be used.

The amine-based catalyst may be classified into primary amine (NH₂-R₁), secondary amine (NH-R₁,-R₂), and tertiary amine (N-R₁,-R₂,-R₃), where the substituted hydrocarbon (R₁,R₂,R₃) may be an aliphatic or aromatic chain. The amine-based catalyst is not limited thereto, but may be diethylamine, diisopropylamine, diisopropanolamine, di-n-propylamine, di-n-butylamine, diisobutylamine, di-sec-butylamine, diallylamine, diamylamine, N-ethyl-1,2-dimethylpropylamine, N-methylhexylamine, di-n-octylamine, piperidine, 2-pipecholine, 3-piecholine, 4-piecholine, morpholine, or a mixture thereof.

Meanwhile, by the composition provided in the present disclosure, a certain pattern may be formed on a surface of the coating film, and in this case, the amine-based catalyst plays a major role. Specifically, when the composition is applied and then cured at a high temperature, a predetermined pattern may be formed on surface due to a difference in a curing speed between the inside and the surface of the coating film, and in this case, in order to obtain advantageously obtain this, the amine-based is preferably selected and used as a material having higher volatility than the acid catalyst.

If a content of the acid catalyst in the composition provided in the present disclosure is less than 0.05 parts by weight or a content of the amine-based catalyst is less than 0.05 parts by weight, the curing temperature of the coating film becomes excessively high, making it impossible to maintain the physical properties of the coating film. On the other hand, if the content of the acid catalyst exceeds 3.0 parts by weight or the content of the amine-based catalyst exceeds 5.0 parts by weight, hardening occurs rapidly or stability over time of the solution deteriorates.

In general, when wax is included in a paint, wax is used for the purpose of improving the frictional properties of the coating film, but in the present disclosure, it is significant that it is used for the purpose of forming a certain pattern when the coating film is cured after applying the solution.

In the present disclosure, the (e) wax may be included in an amount of 0.05 to 5.0 parts by weight, more advantageously, in an amount of 0.1 to 3.0 parts by weight, based on a total of 100 parts by weight.

Specifically, in the present disclosure, in order to form a pattern such as a wrinkle pattern or a concavo-convex structure on a surface of a coating film in a dried state obtained after application and curing of the composition, it is preferable to use an insoluble wax that is not easily soluble in organic solvent. An insoluble wax exists in a solid state at room temperature and low temperature, and is evenly distributed in a paint, but the wax is melted by high-temperature curing, and a difference in local surface tension occurs depending on the presence or absence of wax components on a surface of the coating film. Therefore, the insoluble wax may be a starting point where patterns such as wrinkles, or the like, are formed.

The insoluble wax may be, but is not limited to, at least one of waxes containing polyethylene, polypropylene, polyvinyl acetate, polystyrene, polystyrene-acrylonitrile, acrylic polymer, and polytetrafluoroethylene.

If a content of the wax in the composition provided in the present disclosure is less than 0.05 parts by weight, wrinkles or irregularities are formed widely and it is difficult to form a certain pattern, whereas if the content thereof exceeds 5.0 parts by weight, the patterns such as wrinkles, irregularities, or the like become too narrow, making it impossible to obtain a homogeneous texture.

In the composition provided in the present disclosure, a solvent may be included as a remainder, other than the components to be formulated for convenience of operation and viscosity control. As the solvent, toluene, xylene, isopropanol, solvent naphtha, cellosolve, cellosolve acetate, butyl cellosolve, and the like, may be used, and these solvents may be used alone or as a mixture of two or more.

The viscosity of the composition is adjusted according to a content of the solvent, the content of the solvent is not particularly limited, and the content thereof may be adjusted according to a technique commonly used in the art. The content of the solvent may be adjusted in consideration of a coating amount application amount of the composition and adhesiveness, and the like, for example, it is advantageous in terms of productivity to adjust the viscosity to an extent that it takes 20 to 200 seconds to be discharged from a DIN cup (DIN, 53211).

As described above, the present disclosure is to provide a composite resin composition (Composition 1) containing all of the above components and a composite resin composition (Composition 2) excluding some catalysts and wax components from the above components.

Specifically, the Composition 2 may include (a) a main resin composed of a modified polyester resin, (b) a curing agent, (c) a pigment comprised of an anti-corrosive pigment and a thermally-conductive pigment, and (d) a catalyst comprised of an acid catalyst.

Since the Composition 2 excludes an amine-based catalyst and wax components affecting a surface shape of a dry film obtained after application and curing of the composition, and the dry film formed by the composition 2 does not have a certain pattern, that is, may have a flat surface shape.

Since each of the components is as described above, a detailed description thereof will be omitted. In addition, the content of each component is also as described above, and it should be noted that a content of the components excluded compared to Composition 1, may be replaced with the remaining components.

Meanwhile, the remainder thereof other than the above components in the composition may include a solvent, and the solvent is as described above.

When the composite resin composition provided in the present disclosure, that is, each of Composition 1 and Composition 2 is applied to a specific substrate to form a dry coating film, for the purpose of further improving physical properties of the substrate, additional additives may be further included as needed.

Specifically, regardless of Composition 1 and Composition 2, at least one of a pigment aggregation inhibitor, an anti-foaming agent, and a leveling agent may be further formulated in any composition.

These optional additives are components generally known in the technical field of the present disclosure, and a mixing ratio thereof is not particularly limited, and those skilled in the art will be able to suitably formulate and use these additives as needed.

These optional additives are components generally known in the technical field of the present disclosure, and a mixing ratio thereof is not particularly limited, and those skilled in the art will be able to suitably mix and use these additives as needed.

In the composite resin coated steel sheet according to the present disclosure, a coated steel sheet may be applied as a substrate to which each of the composite resin compositions described above can be applied to different surfaces.

That is, each composite resin composition may be applied to both surfaces of the plated steel sheet, and thus, a thermal radiation coating layer may be included on one surface (first surface) thereof and a weather-resistance coating layer may be included on the other side (second surface).

In the present disclosure, the heat-radiation coating layer formed on the first surface of the plated steel sheet may be formed from composition 1 including a wax component among the above-described composite resin compositions, and the weather-resistance coating layer formed on the second surface may be formed from composition 2 excluding the wax component and some catalyst components.

The composite resin coated steel sheet provided in the present disclosure may be applied to a structure such as a roof or wall of a solar cell. In particular, in the present disclosure, the weather resistance coating layer on the second surface may be contacted to a solar module.

Accordingly, in the plated steel sheet, the first surface corresponds to a lower surface and the second surface corresponds to an upper surface, and the second surface may be naturally exposed to an external environment.

As described above, in the present disclosure, by forming a heat-radiation coating layer on the first surface and a weather resistance coating layer on the second surface of the plated steel sheet, it is possible to effectively radiate heat from a solar cell and lower surface temperature. In addition, in the case of a surface to which the solar module is directly attached, it has excellent weather resistance, and thus has an advantage of being usable in an external environment for a long period of time.

The heat-radiation coating layer and the weather resistance coating layer may have a thickness of 3 to 40 um, based on a thickness of the thermal radiation coating layer and the weather resistance coating layer in a dried state, respectively, and more preferably, have a thickness of 5 to 30 µm.

If the thickness of each coating layer is less than 3 um, a color, hiding power, workability, and solvent resistance of the coating layer formed by the composite resin composition are poor. On the other hand, when the thickness of each coating layer 40 um, a manufacturing cost may increase and workability may be lowered.

Meanwhile, the plated steel sheet may be a galvanized steel sheet. Examples of the galvanized steel sheet include, but an embodiment thereof is not limited thereto, but may be any one of a hot-dip galvanized steel sheet (GI), alloying hot-dip galvanized steel sheet (GA), electro-galvanized steel sheet (EG), alloying aluminum-plated steel sheet (Al-Zn, Al-Zn-Si), and alloying hot-dip galvanized steel sheet (Zn-Al-Mg) .

As a more specific example, the alloying aluminum-plated steel sheet may have a plating layer comprised of Al-55%Zn and Al-8%Zn-0.3%Si, and the alloying hot-dip galvanized steel sheet is a ternary (Zn-xAl- yMg)-based plated steel sheet may have a plating layer comprised of Zn-(1.0~3.0%)Al-(1.0~5.0%)Mg. However, an embodiment thereof is not limited thereto.

As another aspect of the present disclosure, a method for manufacturing the composite resin coated steel sheet described will be described in detail.

In order to manufacture the composite resin coated steel sheet of the present disclosure, a coated steel sheet may be prepared first.

The plated steel sheet may be a galvanized steel sheet, and since the type thereof is the same as described above, it is omitted here.

A composite resin composition may be applied to both surfaces of the coated plated steel sheet prepared as described above, and in this case, it is preferable that Composition 1 including a wax component is applied to a lower surface, corresponding to a first surface of the plated steel sheet, while Composition 2 excluding a wax component and some catalysts are applied to an upper surface, that is a second surface of the plated steel sheet. Here, it should be noted that the second surface of the plated steel sheet is a surface contacted to an actual object to be applied in the present disclosure, that is, a solar module.

In applying each of the composite resin compositions, any well-known method for applying the composition may be applied. However, as an example, one of a bar-coater, a roll coater, a slot-die coater, and a curtain coater may be applied.

According to the above, a final composite resin coated steel sheet may be manufactured by baking and drying the plated steel sheet having the composite resin composition of the present disclosure applied to each surface.

In this case, the drying temperature may be performed in a temperature range of 180 to 260°C, based on Peak Metal Temperature (PMT) of the plated steel sheet. If a baking temperature during the drying is less than 180°C, a reaction between an inorganic material in the composition and the resin, is not sufficient and the coating layer is not robust, while when the baking temperature exceeds 260 °C, an over-curing reaction may occur, there is a problem in that performance of the coating film may rather deteriorate.

Meanwhile, in drying the applied composition, any method generally known in the art may be used. However, an embodiment thereof is not limited thereto, but, for example, a hot-air heating method, an infrared heating method, or an induction heating method may be used.

When the drying method is a hot air heating method, the applied composition may be dried by treating the applied composition with hot air at an ambient temperature of 200 to 340°C for 10 to 50 seconds. In addition, if the method is an induction heating method, it can be dried for 5 to 20 seconds with a frequency range of 5 to 50 MHz and a power of 3 to 15 KW.

Meanwhile, the composite resin coated steel sheet of the present disclosure may be additionally coated in consideration of workability and corrosion resistance of a plated steel sheet corresponding to a substrate, and thus an additional coating film may be formed.

As an example, a pre-treatment layer and a primary coating layer may be sequentially formed on one or both surfaces of the plated steel sheet, and in this case, only the primary coating layer may be formed except for the pre-treatment layer.

The composite resin composition of the present disclosure may be applied on the pre-treatment layer and/or the primary coating layer to form a composite resin coating layer (preferably, a thermal radiation coating layer and a weathering coating layer) intended in the present disclosure. Such a coated steel sheet may have an effect of further improving workability.

The pre-treatment layer and/or the primary coating layer may be located between the plated steel sheet and the composite resin coat layer to be ultimately formed in the present disclosure, and in this case, the composite resin coat layer may be referred to as a top coating film.

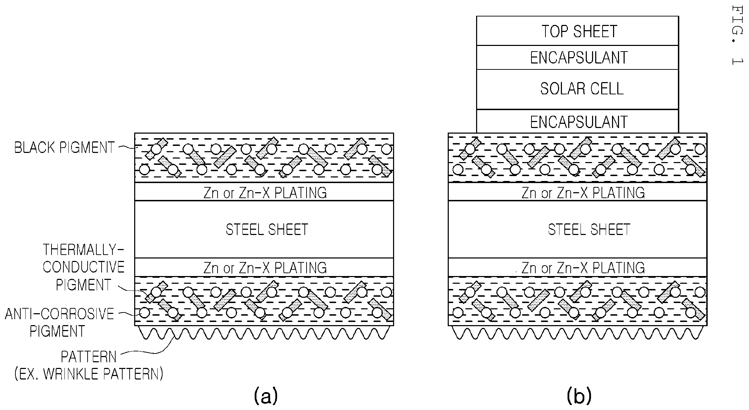

FIG. 1 is a side cross-sectional view of a composite resin coated steel sheet formed using a composite resin composition provided in the present disclosure, and a coating layer made of the composition may have a black color.

As illustrated in (a) of FIG. 1, a pre-treatment layer and/or a primary coating layer additionally formed an upper surface and a lower surface of a plated steel sheet having a zinc-based plated layer is formed on both surfaces may increase adhesion between a steel sheet and a coating layer formed by the composite resin composition, and impart physical properties required for the steel sheet, such as processability and corrosion resistance of steel sheet. A composition for forming the pre-treatment layer and the primary coating layer is not particularly limited, and any coating film known in the art to be applied between the steel sheet and the composite resin coating layer may be used.

Meanwhile, (b) of FIG. 1 illustrates a side cross-sectional view when one surface of the composite resin coated steel sheet is contacted to a solar module. Here, a surface contacted to the solar module is a weather resistance coating layer having a flat surface, and an opposite surface thereof is a thermal radiation coating layer having a predetermined pattern such as a wrinkle pattern or a concavo-convex structure.

Hereinafter, the present disclosure and a manufacturing method thereof will be described in more detail through specific examples. It should be noted that the following examples are only for understanding of the present invention, and are not intended to specify the scope of the present invention. The scope of the present invention may be determined by the matters described in the claims and the matters reasonably inferred therefrom.

### Mode for Invention

### (Example)

A composite resin composition was prepared as follows.

First, 30 to 50 parts by weight of a urethane-modified polyester resin (average molecular weight: 10000 to 30000, hydroxyl value 30, acid value 10mgKOH/g) as a main resin is prepared based on 100 parts by weight of the total composition, and 5 to 10 parts by weight of a cured melamine-type (Hexamethoxymethyl Melamine, HMMM) resin, 0.5-2.0 parts by weight of an acid catalyst blocked with an epoxy resin(Nacure 1419), 0.5 to 3.0 parts by weight of an amine-based catalyst (dibutylamine), 5 to 10 parts by weight of an anti-corrosive pigment (spherical silica, having an average particle diameter of 20 µm) and a thermally-conductive pigment (graphite, having an average particle diameter of 20 pm), and 0.5 to 3.0 parts by weight of a wax (polypropylene, having an average particle diameter of 10 µm) were added and then dispersed. In this case, formulations of each component were performed as illustrated in Table 1 below.

Meanwhile, another composite resin composition for forming a coating layer contacted to a solar module was formulated in the same manner except for an amine catalyst and wax from the above components, and the content of the excluded components was supplemented with a solvent.

An organic solvent (ketone and ester-based petrochemical solvent) was used as a solvent for each composition.

**[Table 1]**

| Classification | Main resin | Curing agent | Anti-corrosive pigment | Thermally-conductive pigment | Acid catalyst | Amine-based catalyst | Wax |
|---|---|---|---|---|---|---|---|
| Inventive example 1 | 30 | 5 | 5 | 5 | 1.0 | 0.5 | 3.0 |
| Inventive example 2 | 30 | 5 | 5 | 10 | 0.5 | 3.0 | 0.5 |
| Inventive example 3 | 30 | 5 | 5 | 10 | 1.0 | 3.0 | 3.0 |
| Inventive example 4 | 30 | 5 | 10 | 5 | 2.0 | 1.5 | 0.5 |
| Inventive example 5 | 30 | 5 | 10 | 10 | 0.5 | 3.0 | 1.5 |
| Inventive example 6 | 30 | 5 | 10 | 10 | 2.0 | 0.5 | 0.5 |
| Inventive example 7 | 30 | 10 | 5 | 5 | 1.0 | 1.5 | 1.5 |
| Inventive example 8 | 30 | 10 | 5 | 10 | 0.5 | 3.0 | 3.0 |
| Inventive example 9 | 30 | 10 | 10 | 5 | 0.5 | 1.5 | 0.5 |
| Inventive example 10 | 30 | 10 | 10 | 5 | 1.0 | 1.5 | 3.0 |
| Inventive example 11 | 30 | 10 | 10 | 5 | 2.0 | 3.0 | 1.5 |
| Inventive example 12 | 50 | 5 | 5 | 5 | 0.5 | 1.5 | 1.5 |
| Inventive example 13 | 50 | 5 | 5 | 5 | 1.0 | 3.0 | 0.5 |
| Inventive example 14 | 50 | 5 | 5 | 10 | 1.0 | 0.5 | 1.5 |
| Inventive example 15 | 50 | 5 | 5 | 10 | 2.0 | 1.5 | 0.5 |
| Inventive example 16 | 50 | 5 | 10 | 10 | 0.5 | 0.5 | 0.5 |
| Inventive example 17 | 50 | 5 | 10 | 10 | 1.0 | 0.5 | 3.0 |
| Inventive example 18 | 50 | 5 | 10 | 10 | 2.0 | 1.5 | 1.5 |
| Inventive example 19 | 50 | 10 | 5 | 5 | 1.0 | 3.0 | 3.0 |
| Inventive example 20 | 50 | 10 | 5 | 10 | 1.0 | 1.5 | 0.5 |
| Inventive example 21 | 50 | 10 | 10 | 5 | 0.5 | 3.0 | 1.5 |
| Inventive example 22 | 50 | 10 | 10 | 5 | 2.0 | 0.5 | 0.5 |
| Inventive example 23 | 50 | 10 | 10 | 10 | 0.5 | 0.5 | 3.0 |
| Inventive example 24 | 50 | 5 | 5 | 5 | 0.5 | 1.5 | 1.5 |
| Inventive example 25 | 50 | 5 | 5 | 5 | 0.5 | 1.5 | 1.5 |
| Inventive example 26 | 50 | 5 | 5 | 5 | 0.5 | 1.5 | 1.5 |
| Inventive example 27 | 50 | 5 | 5 | 5 | 0.5 | 1.5 | 1.5 |
| Inventive example 28 | 50 | 5 | 5 | 5 | 0.5 | 1.5 | 1.5 |
| Comparative example 1 | 30 | 5 | 5 | 0 | 1.0 | 0 | 0 |
| Comparative example 2 | 30 | 10 | 10 | 0 | 1.5 | 0 | 1.0 |
| Comparative example 3 | 50 | 5 | 5 | 0 | 1.0 | 0 | 0 |
| Comparative example 4 | 50 | 10 | 10 | 0 | 1.5 | 0 | 1.0 |

(In Table 1, each component is based on parts by weight.)

A composite-resin-coated steel sheet in which a coating layer was formed using each solution prepared as described above was prepared as follows.

First, after preparing each of the plated steel sheets (single-sided coating weight of 60 g/m²) illustrated in Table 2, a pre-treatment layer and a primary coating layer were sequentially formed on both surfaces of the plated steel plate. In this case, a pre-treatment solution was roll-coated so that a density of the pre-treatment solution in a dried state was 100±50mg/m², and dried by hot air at 100°C, to form a pre-treatment layer, and a primer solution was roll-coated so that a thickness of the primer solution in a dried state was 5±2 um, and then baked and dried at PMT=210°C and then cooled, to form a primary coating layer.

By dividing upper and lower surfaces of the plated steel sheet on which the pre-treatment layer and the primary coating layer are sequentially formed as described above, a composition capable of forming a weather resistance coating layer on the upper surface that is, a composition solution excluding an amine-based catalyst and a wax component was applied, and a composition solution capable of forming a thermal radiation coating layer was applied to the lower surface. In this case, each of the composition solutions was applied by a roll-coating method so that a thickness of the composition solution in a dried state was 10 to 25 um, and then cured and dried at PMT = 232°C, and then cooled to manufacture a composite resin coated steel sheet having a coating layer formed on both surfaces of the plated steel sheet.

Quality evaluation was performed on each of the composite resin coated steel sheets manufactured as described above, and the results thereof were shown in Tables 2 and 3.

First, a thickness of the coating layer formed using the above-described composition solution was measured with a non-destructive portable coating thickness gauge.

Pencil hardness was evaluated by the presence or absence of scratches after drawing a 10 cm line at a 45° angle with a load of 1000 ± 10 g using a Mitsubishi pencil (HB-4H) .

Corrosion resistance was evaluated by a complex salt spray method (Cyclic Corrosion Test, CCT). In this case, a process in which salt spray (under conditions of a concentration of 5%, and spray pressure of 1kg/cm² at 35 °C) was performed for 5 hours at relative humidity of 95%, then dried for 2 hours at relative humidity of 30% and a temperature of 70 °C, and then processed for 3 hours at relative humidity of 95% and a temperature of 50 °C was set as 1 cycle, and after 100 cycles were repeated, the corrosion resistance was evaluated by an area of red rust occurring on a surface of the coated steel sheet.

As for evaluation criteria, a corrosion area of 0% was represented as ⊚, a corrosion area of 5% or less was represented as o, a corrosion area exceeding 5% and less than 30% was represented as △, and a corrosion area exceeding 30% was represented as ×.

Workability evaluation was performed by OT-bending, as bending workability, in which the coated steel sheet was put in a vise and bent 180° at a pressure of 1 kgf, and then tightened until it became flat. Thereafter, when a scotch tape was attached to the surface of the bent coating film and the coating film was peeled off, cracks occurred in the surface peeled off from the tape and the presence or absence of the coating film was evaluated.

As for evaluation criteria, a state in which non-coating film cracks occurred and no peeling occurred was represented as ⊚, fine cracks in the coating film occurred and no peeling occurred was represented as o, severe cracks occurred and no peeling occurred was represented as △, and severe cracks occurred and coating film is peeled off was represented as ×.

Surface roughness was measured using a three-dimensional roughness meter (Leica Co., DCM8).

As for evaluation criteria, 10 µm or more may be evaluated as ⊚, 7 µm or more to less than 10 um may be evaluated as o, 5 um or more to less than 7 µm may be evaluated as △, and less than 5 um may be evaluated as ×, depending on the measured roughness value.

As for acid resistance, after a 5% hydrochloric acid solution was applied to a coating film, a surface thereof was covered, and a surrounding region was shielded with Vaseline, and a state of the coating film was evaluated after leaving the same at 25°C for 24 hours.

As for the evaluation criteria, a state without any trace was set as 5, and a state of being entirely peeled was set as 1, so that each state was evaluated as 1, 2, 3, 4, and 5 according to a degree of peeling.

As for alkali resistance, after a 5% sodium hydroxide solution was applied to a coating film, a surface thereof was covered, and a surrounding region was shielded with Vaseline, and a state of the coating film was evaluated after leaving the same at 25°C for 24 hours.

As for the evaluation criteria, a state without any trace was set as 5, and a state of being entirely peeled was set as 1, so that each state was evaluated as 1, 2, 3, 4, and 5 according to a degree of peeling.

Weather resistance was measured using a Q.U.V-se device from Q-PANEL, USA, and a value measured by adjusting an UV wavelength to A Type (340 nm) was indicated as Q.U.V-A, and a value measured by adjusting an UV wavelength to B Type (313 nm) was indicated as Q.U.V-B. In this case, in the case of Type A, UV was irradiated thereon at 60°C for 8 hours per cycle, maintained for 1000 hours at 50°C for 4 hours, and then a retention rate thereof was evaluated by comparing with initial glossiness of the coating film. In the case of B type, it was performed by setting a temperature to 40°C when maintaining after UV was irradiated thereon under the same conditions.

As for evaluation criteria, a case in which glossiness is maintained to be 90% or more compared to initial glossiness was represented as ⊚, a case in which glossiness is maintained to be 85% or more to less than 90% was represented as o, a case in which glossiness is maintained to be 80% or more to less than 85% was represented as △, and a case in which glossiness is maintained to be less than 80% was represented as ×.

Thermal diffusion and thermal conductivity were measured according to the KS L 1604: 2017 test method by the Laser Flash method (LFA 457 from NETZSCH).

Thermal radiation rate was measured according to the KS L 2514: 2011 test method using an FT-IR spectrometer (DIMAC M4500).

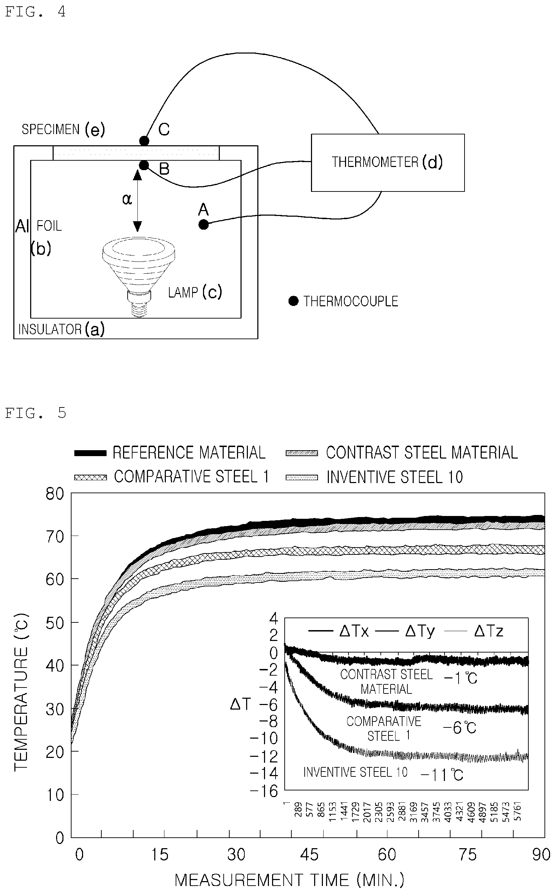

As illustrated in FIG. 4, heat-radiation evaluation was measured by manufacturing a test device simulating a solar module. The test device was made of styrofoam (a, heat insulating material) with a thickness of 26 mm and a size of 340 × 265 × 195 mm, and an inside thereof was coated with aluminum foil (b). In addition, an infrared lamp (c) was installed in a central portion of a bottom of the test device, and a thermometer (d) was installed in a middle portion between the infrared lamp and an upper end of the test device.

The coated steel sheet to be measured was placed on an upper portion of the open test device, and after attaching thermocouples to an internal temperature A of a box and both surfaces B and C of the steel sheet, a change in surface temperature was measured. In this case, a specimen (e) of the coated steel sheet was prepared by cutting the same into a size of 150 cm wide × 150 cm long, and it was attached to an upper surface open to be 50 mm (α) in the infrared lamp of the measuring device and sealed. The thermal radiation temperature was calculated as a difference in temperature of the coated steel sheet for an alloying plated steel sheet in which a solar module was simulated in a non-coated state after 60 minutes of measurement (thermal radiation temperature (ΔT)=(temperature of measurement specimen (coated steel sheet) - (temperature of non-coated alloying plated steel sheet)) was calculated and illustrated.

Here, the alloying plated steel sheet for comparison with the coated steel sheet corresponds to a 'comparison steel material' of Tables 2 and 3, and is a Zn-1.5%Al-1.5%Mg plated steel sheet, which is only pre-treated on the plating layer, which is an alloying hot-dip galvanized steel sheet without forming a primary coating layer and a composite resin coating layer.

**[Table 2]**

| Classification (composition) | Plated steel sheet | Thickness of coating film (*µ*m) | Surface roughness (Ra, *µ*m) | Pencil hardness | Corrosion resistance | Processiability | Chemical resistance | Acid resistance | Alkali resistance | Reference |
|---|---|---|---|---|---|---|---|---|---|---|
| Inventive example 1 | Zn-xAl-yMg (x=1.5%, y=2.5%) (x=1.5%, y=3.0%) | 10 | 8 ± 1 | 2H | ⊚ | ⊚ | ⊚ | ⊚ | ⊚ | Inventive steel 1 |
| Inventive example 2 | | 20 | 10 ± 1 | 2H | ⊚ | ⊚ | ⊚ | ⊚ | ⊚ | Inventive steel 2 |
| Inventive example 3 | | 10 | 8 ± 1 | 2H | ⊚ | ⊚ | ⊚ | ⊚ | ⊚ | Inventive steel 3 |
| Inventive example 4 | | 20 | 10 ± 1 | 2H | ⊚ | ⊚ | ⊚ | ⊚ | ⊚ | Inventive steel 4 |
| Inventive example 5 | | 10 | 8 ± 1 | 2H | ⊚ | ⊚ | ⊚ | ⊚ | ⊚ | Inventive steel 5 |
| Inventive example 6 | | 20 | 10 ± 1 | 2H | ⊚ | ⊚ | ⊚ | ⊚ | ⊚ | Inventive steel 6 |
| Inventive example 7 | | 10 | 8 ± 1 | 2H | ⊚ | ⊚ | ⊚ | ⊚ | ⊚ | Inventive steel 7 |
| Inventive example 8 | | 20 | 10 ± 1 | 2H | ⊚ | ⊚ | ⊚ | ⊚ | ⊚ | Inventive steel 8 |
| Inventive example 9 | | 10 | 8 ± 1 | 2H | ⊚ | ⊚ | ⊚ | ⊚ | ⊚ | Inventive steel 9 |
| Inventive example 10 | | 20 | 10 ± 1 | 2H | ⊚ | ⊚ | ⊚ | ⊚ | ⊚ | Inventive steel 10 |
| Inventive example 11 | | 10 | 8 ± 1 | 2H | ⊚ | ⊚ | ⊚ | ⊚ | ⊚ | Inventive steel 11 |
| Inventive example 12 | | 20 | 10 ± 1 | 2H | ⊚ | ⊚ | ⊚ | ⊚ | ⊚ | Inventive steel 12 |
| Inventive example 13 | | 10 | 8 ± 1 | 2H | ⊚ | ⊚ | ⊚ | ⊚ | ⊚ | Inventive steel 13 |
| Inventive example 14 | | 20 | 10 ± 1 | 2H | ⊚ | ⊚ | ⊚ | ⊚ | ⊚ | Inventive steel 14 |
| Inventive example 15 | | 10 | 8 ± 1 | 2H | ⊚ | ⊚ | ⊚ | ⊚ | ⊚ | Inventive steel 15 |
| Inventive example 16 | | 20 | 10 ± 1 | 2H | ⊚ | ⊚ | ⊚ | ⊚ | ⊚ | Inventive steel 16 |
| Inventive example 17 | | 10 | 8 ± 1 | 2H | ⊚ | ⊚ | ⊚ | ⊚ | ⊚ | Inventive steel 17 |
| Inventive example 18 | | 20 | 10 ± 1 | 2H | ⊚ | ⊚ | ⊚ | ⊚ | ⊚ | Inventive steel 18 |
| Inventive example 19 | | 10 | 8 ± 1 | 2H | ⊚ | ⊚ | ⊚ | ⊚ | ⊚ | Inventive steel 19 |
| Inventive example 20 | | 20 | 10 ± 1 | 2H | ⊚ | ⊚ | ⊚ | ⊚ | ⊚ | Inventive steel 20 |
| Inventive example 21 | | 10 | 8 ± 1 | 2H | ⊚ | ⊚ | ⊚ | ⊚ | ⊚ | Inventive steel 21 |
| Inventive example 22 | | 20 | 10 ± 1 | 2H | ⊚ | ⊚ | ⊚ | ⊚ | ⊚ | Inventive steel 22 |
| Inventive example 23 | | 10 | 8 ± 1 | 2H | ⊚ | ⊚ | ⊚ | ⊚ | ⊚ | Inventive steel 23 |
| Inventive example 12 | EG | 20 | 10 ± 1 | 2H | ⊚ | ⊚ | ⊚ | ⊚ | ⊚ | Inventive steel 24 |
| Inventive example 12 | GA | 20 | 10 ± 1 | 2H | ⊚ | ⊚ | ⊚ | ⊚ | ⊚ | Inventive steel 25 |
| Inventive example 12 | GI | 20 | 10 ± 1 | 2H | ⊚ | ⊚ | ⊚ | ⊚ | ⊚ | Inventive steel 26 |
| Inventive example 12 | A 1-55%Zn | 20 | 10 ± 1 | 2H | ⊚ | ⊚ | ⊚ | ⊚ | ⊚ | Inventive steel 27 |
| Inventive example 12 | Al-8%Zn -0.3%Si | 20 | 10 ± 1 | 2H | ⊚ | ⊚ | ⊚ | ⊚ | ⊚ | Inventive steel 28 |
| Comparative example 1 | Zn-xAl-yMg (x=1.5%, y=2.5%) (x=1.5%, y=3.0%) | 20 | ≤ 1 | H | ○ | ⊚ | ⊚ | ⊚ | ⊚ | Comparative steel 1 |
| Comparative example 2 | | 10 | ≤ 1 | H | △ | ⊚ | ⊚ | ○ | ⊚ | Comparative steel 2 |
| Comparative example 3 | | 20 | ≤ 1 | H | ○ | ⊚ | ⊚ | ⊚ | ⊚ | Comparative steel 3 |
| Comparative example 4 | | 20 | ≤ 1 | II | ○ | ⊚ | ⊚ | ⊚ | ⊚ | Comparative steel 4 |
| (non-plated) | | 0 | ≤ 1 | - | - | - | - | - | - | Contrast steel material |

(Results of physical property of Table 2 illustrate results measured for a thermal radiation coating layer.)

**[Table 3]**

| Reference | Weather resistance | | Heat-resistance characteristics(Thickness of a material 0.42mm) | | | |
|---|---|---|---|---|---|---|
| | Q.U.V-A | Q.U.V-B | Thermal diffusion (mm²/sec.) | Thermal conductivity (W/mK) | Thermal radiation rate (a.u.) | Thermal radiation temperature (°C) |
| Inventive steel 1 | ⊚ | ⊚ | 12 | 22 | 0.95 | 10 |
| Inventive steel 2 | ⊚ | ⊚ | 10 | 18 | 0.95 | 10 |
| Inventive steel 3 | ⊚ | ⊚ | 12 | 22 | 0.95 | 10 |
| Inventive steel 4 | ⊚ | ⊚ | 10 | 18 | 0.95 | 10 |
| Inventive steel 5 | ⊚ | ⊚ | 12 | 22 | 0.95 | 10 |
| Inventive steel 6 | ⊚ | ⊚ | 10 | 18 | 0.95 | 10 |
| Inventive steel 7 | ⊚ | ⊚ | 12 | 22 | 0.95 | 10 |
| Inventive steel 8 | ⊚ | ⊚ | 10 | 18 | 0.95 | 10 |
| Inventive steel 9 | ⊚ | ⊚ | 12 | 22 | 0.95 | 10 |
| Inventive steel 10 | ⊚ | ⊚ | 10 | 18 | 0.95 | 10 |
| Inventive steel 11 | ⊚ | ⊚ | 12 | 22 | 0.95 | 10 |
| Inventive steel 12 | ⊚ | ⊚ | 10 | 18 | 0.95 | 10 |
| Inventive steel 13 | ⊚ | ⊚ | 12 | 22 | 0.95 | 10 |
| Inventive steel 14 | ⊚ | ⊚ | 10 | 18 | 0.95 | 10 |
| Inventive steel 15 | ⊚ | ⊚ | 12 | 22 | 0.95 | 10 |
| Inventive steel 16 | ⊚ | ⊚ | 10 | 18 | 0.95 | 10 |
| Inventive steel 17 | ⊚ | ⊚ | 12 | 22 | 0.95 | 10 |
| Inventive steel 18 | ⊚ | ⊚ | 10 | 18 | 0.95 | 10 |
| Inventive steel 19 | ⊚ | ⊚ | 12 | 22 | 0.95 | 10 |
| Inventive steel 20 | ⊚ | ⊚ | 10 | 18 | 0.95 | 10 |
| Inventive steel 21 | ⊚ | ⊚ | 12 | 22 | 0.95 | 10 |
| Inventive steel 22 | ⊚ | ⊚ | 10 | 18 | 0.95 | 10 |
| Inventive steel 23 | ⊚ | ⊚ | 12 | 22 | 0.95 | 10 |
| Inventive steel 24 | ⊚ | ⊚ | 10 | 18 | 0.95 | 10 |
| Inventive steel 25 | ⊚ | ⊚ | 10 | 18 | 0.95 | 10 |
| Inventive steel 26 | ⊚ | ⊚ | 10 | 18 | 0.95 | 10 |
| Inventive steel 27 | ⊚ | ⊚ | 10 | 18 | 0.95 | 10 |
| Inventive steel 28 | ⊚ | ⊚ | 10 | 18 | 0.95 | 10 |
| Comparative steel 1 | ⊚ | ⊚ | 10 | 18 | 0.85 | 5 |
| Comparative steel 2 | ⊚ | ⊚ | 12 | 20 | 0.85 | 4 |
| Comparative steel 3 | ⊚ | ⊚ | 10 | 18 | 0.85 | 4 |
| Comparative steel 4 | ⊚ | ⊚ | 10 | 18 | 0.85 | 4 |
| Contrast steel material | - | - | 18 | 55 | 0.3 | 0 |

(In Table 3, a weather-resistance characteristic illustrates a measurement result for a thermal radiation coating layer, and a heat-resistance characteristic illustrates a measurement result for a material itself on which a thermal radiation coating layer and a weather resistance coating layer are formed.)

As illustrated in Tables 1 to 3, it can be seen that, in a composite resin coated steel sheet (Inventive steels 1 to 28) having a thermal radiation coating layer formed on one surface of the plated steel sheet and a weather resistance coating layer formed on the other surface of the plated steel sheet using the composite resin composition provided in the present disclosure, not only excellent weather resistance but also excellent heat-radiation characteristics were exhibited.

In particular, in the composite resin coated steel sheet of the present disclosure, a surface on which a weather resistance coating layer is formed is contacted to a solar module, while a thermal radiation coating layer is formed on an opposite surface thereto to effectively radiate heat from the surface of the module to lower a surface temperature, and thus it has an effect that may be suitably applied as a building-integrated roofing material or wall having excellent weather resistance.

Meanwhile, the coated steel sheets (Comparative steels 1 to 4) prepared using a composition deviating from formulation of the component proposed in the present disclosure showed a significantly lower thermal radiation temperature than the Inventive steels due to poor thermal radiation rate.

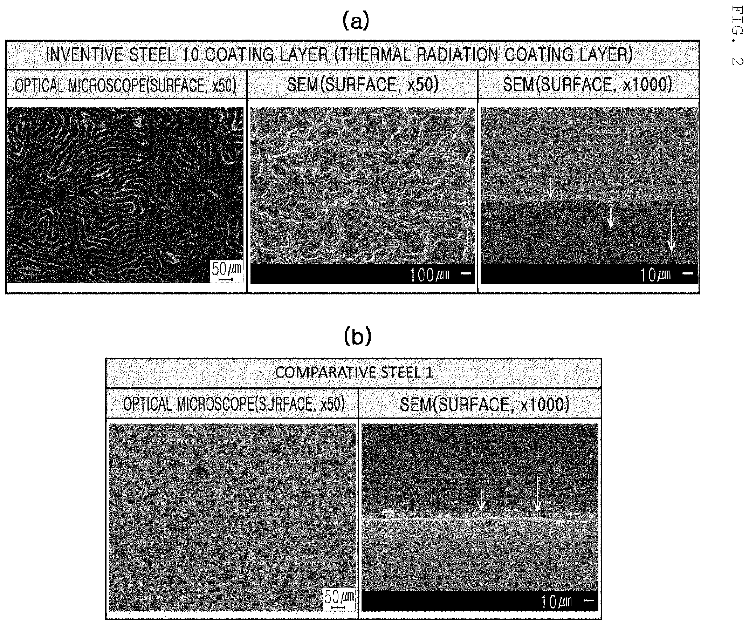

FIG. 2 is a photograph of a surface and cross-section of the coating layer of the inventive steel 10 and the comparative steel 1, especially a thermal radiation coating layer, measured with a microscope (optical microscope, scanning electron microscope (SEM)).

As illustrated in FIG. 2, in the case of inventive steel 10, it can be confirmed that a wrinkle pattern is constantly formed on a surface of the thermal radiation coating layer, whereas in the case of comparative steel 1, it can be confirmed that no such pattern is observed.

In the photograph of the cross-section of each coating layer, the 'left arrow' indicates a primer coating layer, and the 'middle and right arrows' indicate the thermal radiation coating layer.

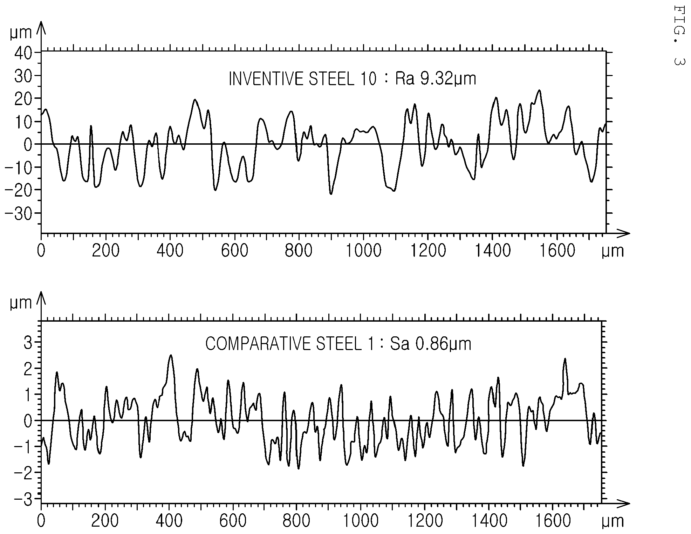

FIG. 3 is a graph measuring surface roughness of Inventive steel 10 and Comparative steel 1.

As illustrated in FIG. 3, it can be seen that the surface roughness of comparative steel 1 is very low compared to inventive steel 10.

FIG. 5 is a graph illustrating a temperature change according to a measurement time when evaluating heat-radiation properties. In this case, Inventive steel 1, Comparative Steel 1,and a contrast steel material were compared with a reference material, corresponding to an untreated specimen (pure coated plated steel sheet not treated at all until pre-treatment or undercoating).

As illustrated in FIG. 5, it can be seen that a contrast steel material in which the coating layer is not formed at all by the composition according to the present disclosure has a very insignificant heat radiation effect even if time continues. In the case of Comparative Steel 1, although the heat radiation effect may be confirmed, it can be seen that the effect does not reach an extent of Inventive Example 10 corresponding to the present disclosure.

While example embodiments have been shown and described above, it will be apparent to those skilled in the art that modifications and variations could be made without departing from the scope of the present disclosure as defined by the appended claims.

## Claims

1. A composite resin composition having excellent weather resistance and heat-radiation characteristics, the composite resin composition including, with respect to a total of 100 parts by weight:
(a) 20 to 60 parts by weight of a main resin made of a modified polyester resin;
(b) 3 to 20 parts by weight of a curing agent;
(c) pigment: 1 to 20 parts by weight of an anti-corrosive pigment, and 1 to 20 parts by weight of a thermally-conductive pigment;
(d) catalyst: 0.05 to 3.0 parts by weight of an acid catalyst, and 0.05 to 5.0 parts by weight of an amine-based catalyst;
(e) 0.05 to 5.0 parts by weight of a wax; and
(d) a remainder of solvent,
wherein a wrinkle pattern or a concavo-convex structure is formed on a surface of a dry film.

2. The composite resin composition having excellent weather resistance and heat-radiation characteristics of claim 1, wherein the amine-based catalyst and wax are not included in the composite resin composition, and
a wrinkle pattern or a concavo-convex structure is not formed on a surface of the dry film.

3. The composite resin composition having excellent weather resistance and heat-radiation characteristics of claim 1, wherein the modified polyester resin has an average molecular weight (Mw) of 5000 to 50000.

4. The composite resin composition having excellent weather resistance and heat-radiation characteristics of claim 1, wherein the modified polyester resin has a hydroxyl (OH) group of 20 to 60, and has an acid value of 1 to 20 mgKOH/g.

5. The composite resin composition having excellent weather resistance and heat-radiation characteristics of claim 1, wherein the curing agent is a melamine-based curing agent, which is at least one selected from hexa(N-butoxy)methylmelamine, hexa(Iso-butoxy)methylmelamine, hexa(N-propyl)methylmelamine, hexa(Iso-propyl)methylmelamine, hexaethoxymethylmelamine and hexamethoxymethylmelamine.

6. The composite resin composition having excellent weather resistance and heat-radiation characteristics of claim 1, wherein the anti-corrosive pigment is a silicate compound, which is at least one of lithium polysilicate, sodium polysilicate, potassium polysilicate and colloidal silica,
wherein the thermally-conductive pigment is a black organic-inorganic pigment, which is at least one of carbon black, carbon nanotube, graphite and graphene.

7. The composite resin composition having excellent weather resistance and heat-radiation characteristics of claim 1, wherein the acid catalyst is sulfonic acid blocked with an organic chain, which is p-toluenesulfonic acid, dodecylbenzene disulfonic acid, dinonyltoluene disulfonic acid, dinonylnaphthalenesulfonic acid, or a mixture thereof.

8. The composite resin composition having excellent weather resistance and heat-radiation characteristics of claim 7, wherein the blocking is performed using an epoxy resin-based or an amine-based compound.

9. The composite resin composition having excellent weather resistance and heat-radiation characteristics of claim 1, wherein the amine-based catalyst is divided into primary amine (NH₂-R₁), secondary amine (NH-R₁,-R₂), tertiary amine (N-R₁,-R₂,-R₃), where the substituted hydrocarbon (R₁,R₂,R₃) is an aliphatic or aromatic chain.

10. The composite resin composition having excellent weather resistance and heat-radiation characteristics of claim 9, wherein the amine-based catalyst is diethylamine, diisopropylamine, diisopropanolamine, di-n-propylamine, din-butylamine, diisobutylamine, di-sec-butylamine, diallylamine, diamylamine, N-ethyl-1,2-dimethylpropylamine, N-methylhexylamine, di-n-octylamine, piperidine, 2-pipecholine, 3-piecholine, 4-piecholine, molpoline or a mixture thereof.

11. The composite resin composition having excellent weather resistance and heat-radiation characteristics of claim 1, wherein the wax is an insoluble wax, and wherein the wax is at least one of waxes containing polyethylene, polypropylene, polyvinyl acetate, polystyrene, polystyrene-acrylonitrile, acrylic polymer and polytetrafluoroethylene.

12. The composite resin composition having excellent weather resistance and heat-radiation characteristics of claim 1 or 2, further comprising:
at least one of a pigment aggregation inhibitor, an anti-foaming agent, and a leveling agent.

13. A composite-resin-coated steel sheet, comprising:
a plated steel sheet;
a thermal radiation coating layer on a first surface of the plating steel sheet; and
a weather resistance coating layer on a second surface of the plating steel sheet,
wherein the thermal radiation coating layer is formed by a composition of claim 1 to form a wrinkle pattern or a concavo-convex structure on a surface thereof, and the weather resistace coating layer is formed by a composition of claim 2.

14. The composite-resin-coated steel sheet of claim 13, wherein the weather resistance coating layer on the second surface is a surface contacted to a solar module.

15. The composite-resin-coated steel sheet of claim 13, wherein a thickness of the thermal radiation coating layer and the weather resistance coating layer in a dried state is 3 to 40 µm, respectively.

16. The composite-resin-coated steel sheet of claim 13, wherein the plated steel sheet is a galvanized steel sheet, wherein the galvanized steel sheet is any one of a hot-dip galvanized steel sheet (GI), an alloying hot-dip galvanized steel sheet (GA), an electro-galvanized steel sheet (EG), an alloying aluminum-plated steel sheet (Al-Zn, Al-Zn-Si), an alloying hot-dip galvanized steel sheet(Zn-Al-Mg) .

17. A method for manufacturing a composite-resin-coated steel sheet, comprising operations of:
a) preparing a plated steel sheet;
b) applying a composition of claim 1 to a first surface of the plated steel sheet and applying a composition of claim 2 to a second surface thereof; and
c) drying the composition applied to the first and second surfaces at 180 to 260°C based on a peak metal temperature (PMT),
wherein the second surface is a surface contacted to a solar module.

18. The method for manufacturing a composite-resin-coated steel sheet of claim 17, wherein the operation of applying the composition thereto is performed by one of methods of a bar-coater, a roll coater, a slot-die coater, and a curtain coater.

19. The method for manufacturing a composite-resin-coated steel sheet of claim 17, wherein the operation of drying the composition is performed by one of a hot air heating method, an infrared heating method, or an induction heating method.
